# EUROPÄISCHE PATENTSCHRIFT

(11) **EP 1 275 008 B1**
(45) Veröffentlichungstag und Bekanntmachung des Hinweises auf die Patenterteilung: **31.05.2006**
(21) Anmeldenummer: 01940110.8
(22) Anmeldetag: 30.03.2001
(51) Int. Cl.: G01R 19/00, G01R 31/34

(54) **SCHALTUNGSANORDNUNG ZUR MESSUNG DER STROMAUFNAHME EINER TRANSISTORGESTEUERTEN LAST**
CIRCUIT ARRANGEMENT FOR MEASURING THE CURRENT CONSUMPTION OF A TRANSISTOR-CONTROLLED LOAD
CIRCUIT POUR MESURER LA CONSOMMATION DE COURANT D'UNE CHARGE COMMANDEE PAR TRANSISTOR

(30) Priorität: 18.04.2000 DE 10019240
(43) Veröffentlichungstag der Anmeldung: 15.01.2003
(73) Patentinhaber: Fujitsu Siemens Computers GmbH, 80807 München (DE)
(72) Erfinder: BUSCH, Peter, 86179 Augsburg (DE)
(74) Vertreter: Epping - Hermann - Fischer
(86) Internationale Anmeldenummer: PCT/DE2001/001211
(87) Internationale Veröffentlichungsnummer: WO 2001/079864

(56) Entgegenhaltungen:
- US-A- 5 828 308
- US-A- 5 867 014
- PATENT ABSTRACTS OF JAPAN vol. 1995, no. 06, 31. Juli 1995 (1995-07-31) & JP 07 077546 A (NIPPONDENSO CO LTD), 20. März 1995 (1995-03-20)

## Beschreibung

Die Erfindung betrifft eine Schaltungsanordnung zur Messung der Stromaufnahme einer transistorgesteuerten Last, insbesondere eines Elektromotors. Die Aufgabe solcher Schaltungsanordnungen ist, den Strom in einem Laststromkreis zu erfassen, um dadurch eine Regelung der Last zu ermöglichen. Die Messung des Stromes erfolgt meist mit einem Meßwiderstand, der dabei in Reihe zu der Last geschaltet ist, so daß über dem Widerstand eine gemäß der Beziehung U = R * I dem Strom proportionale Meßspannung abgegriffen werden kann. Ein Problem einer solchen Anordnung besteht darin, daß in dem Meßwiderstand eine verhältnismäßig große Leistung in Wärme umgesetzt wird, da der Meßwiderstand nicht zu klein sein darf, um zur Auswertung eine ausreichend hohe Meßspannung zu erhalten. Besonders bei großen Strömen im Laststromkreis erlangt dieses Problem größere Bedeutung, da die Verlustleistung quadratisch zum Laststrom steigt.

Aufgabe der Erfindung ist es daher, eine Schaltungsanordnung anzugeben, bei der durch die Messung des Laststromes verursachte Verlustleistungen sehr gering sind, wobei der Aufbau dieser Schaltungsanordnung aber trotzdem einfach sein soll.

Diese Aufgabe wird durch eine Schaltungsanordnung gelöst mit einem Ausgangs-Bipolartransistor, der als Spannungsfolger geschaltet ist, einer Ansteuereinrichtung zur Ansteuerung der Basis des Ausgangstransistors, einem Meßwiderstand und einer Meßvorrichtung, die den Spannungsabfall über dem Meßwiderstand erfaßt. Dabei liegt der Meßwiderstand in einem Parallelzweig zu der Basis-Kollektor-Strecke des Ausgangstransistors.

Die erfindungsgemäße Schaltungsanordnung macht sich zunutze, daß sich bei einem als Spannungsfolger geschalteten Transistor der Steuerstrom an der Basis proportional zu dem Emitter-Kollektor-Strom, also dem Laststrom verhält. Der Steuerstrom und der Laststrom sind über die sogenannte Vorwärtsverstärkung des Ausgangstransistors, die in einem weiten Bereich nahezu konstant ist, miteinander gekoppelt. Ein erster großer Vorteil ergibt sich daraus, daß die in dem Meßwiderstand umgesetzte Verlustleistung um ungefähr einen Faktor 10 bis 50 niedriger ist als bei einer Anordnung nach dem Stand der Technik. Somit kann der Widerstand problemlos in eine Ansteuereinrichtung integriert werden, die beispielsweise als integrierte Schaltung ausgeführt ist. Es ergibt sich ein weiterer Vorteil dadurch, daß nämlich auf diese Weise ein die Ansteuereinrichtung enthaltender Baustein mit einem Pin weniger realisiert werden kann, da der Pin, an den ansonsten die Meßspannung angelegt wird, entfallen kann.

In einer vorteilhaften Ausgestaltung der Erfindung werden in einer mit der Strommeßeinrichtung verbundenen Auswerteinrichtung Impulse ausgewertet, die im Ansteuerstrom des Ausgangstransistors enthalten sind. Dies ist vorteilhaft, weil die Vorwärtsstromverstärkung des Ausgangstransistors in der Regel nicht exakt bekannt ist. Bei Auswertung von Impulsen, bei der oft nur der Zeitpunkt ihres Auftretens von Interesse ist, ist der Absolutwert der Spannung oder des Stromes unwichtig.

Weitere Einzelheiten und Ausgestaltung der Erfindung sind in den Unteransprüchen angegeben.

Die Erfindung wird nachfolgend anhand eines Ausführungsbeispieles näher erläutert. Es zeigt:
- Figur 1: eine Schaltungsanordnung gemäß dem Stand der Technik und
- Figur 2: eine Schaltungsanordnung gemäß der Erfindung.

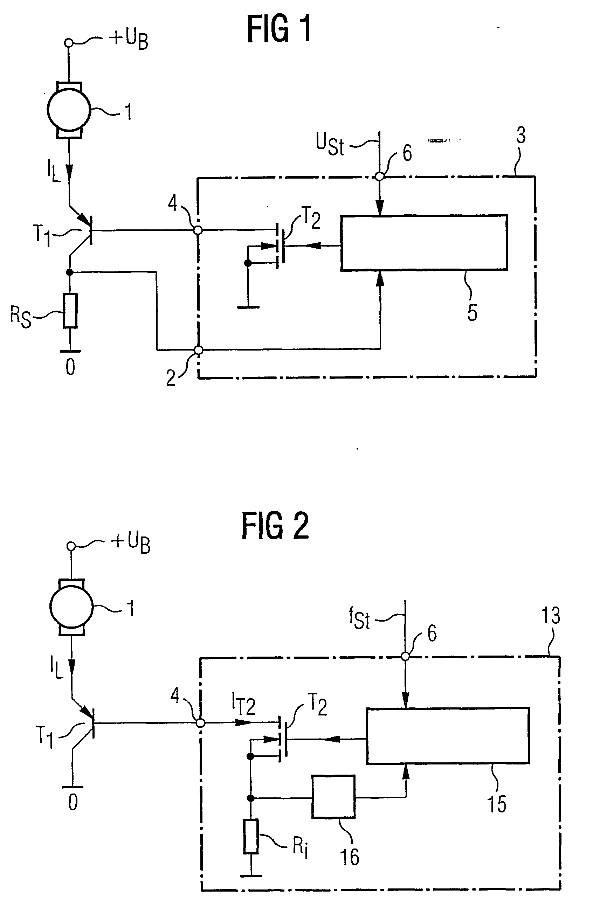

Die Figur 1 zeigt eine Schaltungsanordnung nach dem Stand der Technik, die zur Steuerung eines Lüftermotors 1 eingesetzt ist. Zwischen eine Betriebsspannungsquelle U_{B} und das Bezugspotential 0 sind der Lüfter 1, ein Ausgangstransistor T1 und ein Meßwiderstand R_{S} in Reihe geschaltet. Der Meßwiderstand R_{S} ist also zwischen den Transistor T1 und das Bezugspotential 0 geschaltet. Die Spannung über dem Meßwiderstand R_{S} wird abgegriffen und an einen Meßeingang 2 einer Ansteuereinrichtung 3 gelegt. Der Transistor T1 ist als Spannungsfolger geschaltet. Dadurch ist die Spannungsverstärkung ungefähr 1, die Stromverstärkung h_{FE} liegt typischerweise zwischen dem Faktor 10 und 50. Die Basis des Ausgangstransistors T1 ist mit einem Steuerausgang 4 der Ansteuereinrichtung 3 verbunden. Der Aufbau der Ansteuereinrichtung 3 besteht im wesentlichen aus einem Ansteuertransistor T2, der den Basisstrom des Ausgangstransistors T1 steuert, und einem Regelverstärker 5, der auf der Grundlage des an dem Meßeingang 2 anliegenden Spannungswertes den Ansteuertransistor T2 steuert. An einen Steuereingang 6 kann eine weitere Steuerspannung Uₛₜ angelegt werden, die einen Sollwert für die Ansteuerung des Lüftermotors 1 vorgibt.

Da der Laststrom I_{L} verhältnismäßig groß ist, ist auch die Verlustleistung im Meßwiderstand R_{S} relativ groß, so daß dieser aufgrund der Wärmeentwicklung nicht in eine integrierte Schaltung, die die Ansteuereinrichtung 3 enthält, aufgenommen werden kann.

Eine erfindungsgemäße Schaltungsanordnung ist in der Figur 2 dargestellt. Das Einsatzgebiet der Schaltungsanordnung ist das gleiche, wie bei dem in der Figur 1 dargestellten Stand der Technik, d.h. die Schaltungsanordnung wird zur Steuerung eines Lüftermotors 1 eingesetzt. Der Ausgangstransistor T1 unterscheidet sich nicht von dem in der Figur 1 gezeigten. Der Kollektor des Transistors T1 ist jedoch nicht über einen Meßwiderstand mit dem Bezugspotential 0 verbunden, sondern ist direkt an das Bezugspotential 0 gelegt. Wie beim Stand der Technik ist die Basis des Ausgangstransistors T1 mit einem Steuerausgang 4 einer Ansteuereinrichtung 13 verbunden. Zur Bestimmung des Laststromes I_{L} wertet die Schaltungsanordnung gemäß der Erfindung den Ansteuerstrom I_{T2} des Transistors T1 aus. Dazu ist ein Meßwiderstand R_{I} in den Ansteuerpfad geschaltet. Die Spannung über dem Widerstand R_{I} ist nun ein Maß für die Höhe des Ansteuerstromes I_{T2}. Wenn die Vorwärtsverstärkung h_{FE} des Ausgangstransistors T1 bekannt ist, kann der Laststrom I_{L} aus dem Ansteuerstrom I_{T2} durch Multiplizieren mit der Vorwärtsverstärkung h_{FE} errechnet werden. Im vorliegenden Fall ist jedoch weniger der Absolutwert des Laststromes von Interesse, sondern vielmehr die Zeitpunkte der Kommutierung. Es genügt daher, daß durch den Meßwiderstand R_{I} ein Strom fließt, der dem Laststrom proportional ist. Man kann davon ausgehen, daß die Mindestvorwärtsverstärkung ungefähr 10 beträgt. Die Verlustleistung im Meßwiderstand Ri errechnet sich zu Pₜₒₜ = I_{T2}² * R_{I}. Daraus ergibt sich, daß die Verlustleistung im Widerstand R_{I} wesentlich geringer ist als in dem Meßwiderstand R_{S} gemäß dem Stand der Technik.

Die Spannung über dem Widerstand R_{I} wird abgegriffen und einem Differenzierer 16 zugeführt, da die Frequenz der Kommutierungsimpulse ausgewertet werden soll. Der Differenzierer ist mit dem Regelverstärker 15 verbunden, der somit ein Signal mit Pulsen entsprechend der Frequenz der Kommutierungsimpulse erhält.

Der Regelverstärker 15 steuert wiederum den Ansteuertransistor T2. An einem Steuereingang 6 des Regelverstärkers 15 liegt eine Sollfrequenz fₛₜ an, durch die ein Sollwert zur Steuerung des Lüftermotors 1 vorgegeben wird. Die Sollfrequenz fₛₜ wird mit der gemessenen Frequenz, die der Differenzierer 16 bereitstellt, verglichen und auf der Basis des Vergleichs der Ausgangstransistor T1 gesteuert. Statt einer Sollfrequenz fₛₜ kann auch eine Sollspannung anliegen, mit der dann ein spannungsgesteuerter Oszillator angesteuert wird, so daß wiederum eine Sollfrequenz einstellbar ist.

Aufgrund der geringen Verlustleistung im Widerstand R_{I} kann dieser in die Ansteuereinrichtung 13 integriert werden. Ein zusätzlicher Eingang, der zum Anschluß einer Meßspannung dient, kann somit eingespart werden. Durch die Einsparung eines Pins für einen Meßeingang können die Kosten für die Herstellung der Ansteuereinrichtung deutlich reduziert werden.

In einer anderen Ausführungsform wird als Ausgangstransistor ein npn-Transistor verwendet. Entsprechend sind in einer solchen Ausgestaltung die Polaritäten der Versorgungsspannungen vertauscht. Die zuvor beschriebene Variante mit einem pnp-Transistor hat den Vorteil, daß der Lüfter 1 mit 12 V betrieben werden kann, während für die Ansteuerschaltung eine Versorgung mit 5 V erfolgt. Bei Umkehrung der Polaritäten und Verwendung eines npn-Transistors ist dies nicht mehr möglich.

Für die Variante mit pnp-Transistor ist der Ansteuertransistor ein n-Kanal-FET, während bei einem npn-Transistor ein p-Kanal-FET zu verwenden wäre. N-Kanal-FETs werden wegen ihrer höheren Ladungsträgerbeweglichkeit jedoch im allgemeinen bevorzugt.

## Patentansprüche

1. Schaltungsanordnung zur Messung der Stromaufnahme einer transistorgesteuerten Last, insbesondere eines Elektromotors, mit
- einem Ausgangs-Bipolartransistor (T1), der als Spannungsfolger geschaltet ist,
- einer Ansteuereinrichtung (13) zur Ansteuerung der Basis des Ausgangstransistors (T1),
- einem Meßwiderstand (R_{I}), der in einem Parallelzweig zu der Basis-Kollektor-Strecke des Ausgangstransistors (T1) liegt und
- einer Meßvorrichtung, die den Spannungsabfall über dem Meßwiderstand (R_{I}) erfaßt und die mit der Ansteuervorrichtung verbunden ist.

2. Schaltungsanordnung nach Anspruch 1,
**dadurch gekennzeichnet, daß** Ausgangs-Bipolartransistor (T1) ein pnp-Transistor ist, dessen Kollektor mit einem Bezugspotential (0) und dessen Emitter mit der Last (1) verbunden ist, wobei der andere Anschluß der Last (1) mit einem Versorgungspotential (+U_{B}) verbunden ist

3. Schaltungsanordnung nach Anspruch 1,
**dadurch gekennzeichnet, daß** die Last (1) ein elektronisch kommutierter Elektromotor ist und die Ansteuervorrichtung (13) eine Auswertvorrichtung (16) aufweist, durch die in der Spannung über dem Meßwiderstand (R_{I}) enthaltene Impulse zur Ermittlung der Drehzahl des Elektromotors (1) ausgewertet werden.

4. Schaltungsanordnung nach Anspruch 1,
**dadurch gekennzeichnet, daß** der Meßwiderstand (R_{I}), die Meßvorrichtung und die Auswertvorrichtung (16) Teile der Ansteuervorrichtung (13) und in einem gemeinsamen Bauteilgehäuse angeordnet sind.

5. Schaltungsanordnung nach einem der Ansprüch 1 bis 4,
**dadurch gekennzeichnet, daß** zwischen einen ersten Anschluß des Widerstandes (R_{I}) und den Bipolar-Ausgangstransistor (T1) ein Ansteuertransistor (T2) geschaltet ist, der einen Teil der Ansteuereinrichtung (13) bildet, und daß der andere Anschluß des Meßwiderstandes (R_{I}) mit dem Kollektor des Ausgangstransistors (T1) verbunden ist.

6. Schaltungsanordnung nach Anspruch 5,
**dadurch gekennzeichnet, daß** der Ansteuertransistor (T2) ein Feldeffekttransistor ist.

7. Schaltungsanordnung nach Anspruch 5,
**dadurch gekennzeichnet, daß** zwischen den ersten Anschluß des Meßwiderstandes (R_{I}) und einen Steueranschluß des Ansteuertransistors (T2) ein Regelverstärker (15) geschaltet ist, der aufgrund der Frequenz der gemessenen Impulse den Ansteuertransistor (T2) ansteuert.

8. Verfahren zur Messung der Stromaufnahme einer transistorgesteuerten Last, insbesondere eines Elektromotors, mit einem Bipolar-Ausgangstransistor (T1), der als Spannungsfolger geschaltet ist, wobei die Bestimmung der Stromaufnahme der Last (1) durch die Messung des Ansteuerstromes (I_{T2}) des Bipolar-Ausgangstransistors (T1) erfolgt.

9. Verfahren nach Anpruch 8,
**dadurch gekennzeichnet, daß** in dem Ansteuerstrom (I_{T2}) enthaltene Impulse ausgewertet werden.

## Claims

1. Circuit arrangement for measuring the current consumption of a transistor-controlled load, in particular of an electric motor, having
- an output bipolar transistor (T1) which is connected as a voltage follower,
- a drive device (13) for driving the base of the output transistor (T1),
- a measuring resistor (R_{I}) which is located in a parallel branch to the base-collector path of the output transistor (T1), and
- a measuring device which measures the voltage drop across the measuring resistor (R_{I}) and which is connected to the drive device.

2. Circuit arrangement according to Claim 1, **characterized in that** the output bipolar transistor (T1) is a pnp-type transistor whose collector is connected to a reference potential (0) and whose emitter is connected to the load (1), the other terminal of the load (1) being connected to a supply potential (+U_{B}).

3. Circuit arrangement according to Claim 1, **characterized in that** the load (1) is an electronically commutated electric motor, and the drive device (13) has an evaluation device (16) by means of which pulses contained in the voltage across the measuring resistor (R_{I}) are evaluated in order to determine the rotational speed of the electric motor (1).

4. Circuit arrangement according to Claim 1, **characterized in that** the measuring resistor (R_{I}), the measuring device and the evaluation device (16) are parts of the drive device (13) and are arranged in a common component housing.

5. Circuit arrangement according to one of Claims 1 to 4, **characterized in that** a drive transistor (T2) which forms part of the drive device (13) is connected between a first terminal of the resistor (R_{I}) and the bipolar output transistor (T1), and **in that** the other terminal of the measuring resistor (R_{I}) is connected to the collector of the output transistor (T1).

6. Circuit arrangement according to Claim 5, **characterized in that** the drive transistor (T2) is a field-effect transistor.

7. Circuit arrangement according to Claim 5, **characterized in that** a control amplifier (15) which drives the drive transistor (T2) on the basis of the frequency of the measured pulses is connected between the first terminal of the measuring resistor (R_{I}) and a control terminal of the drive transistor (T2).

8. Method for measuring the current consumption of a transistor-controlled load, in particular of an electric motor, having a bipolar output transistor (T1) which is connected as a voltage follower, the current consumption of the load (1) being determined by measuring the drive current (I_{T2}) of the bipolar output transistor (T1).

9. Method according to Claim 8, **characterized in that** pulses contained in the drive current (I_{T2}) are evaluated.

## Revendications

1. Circuit pour mesurer la consommation de courant d'une charge commandée par transistor, en particulier d'un moteur électrique, avec
- un transistor bipolaire de sortie (T1), qui est monté en étage suiveur de tension,
- un dispositif de commande (13) pour la commande de la base du transistor de sortie (T1),
- une résistance de mesure (R_{I}), qui se trouve dans une branche parallèle à la section base - collecteur du transistor de sortie (T1), et
- un dispositif de mesure, qui détecte la chute de tension à travers la résistance de mesure (R_{I}) et qui est raccordé au dispositif de commande.

2. Circuit selon la revendication 1, **caractérisé en ce que** le transistor bipolaire de sortie (T1) est un transistor pnp, dont le collecteur est raccordé à un potentiel de référence (0) et l'émetteur est raccordé à la charge (1), dans lequel l'autre borne de la charge (1) est reliée à un potentiel d'alimentation (+U_{B}).

3. Circuit selon la revendication 1, **caractérisé en ce que** la charge (1) est un moteur électrique à commutation électronique et le dispositif de commande (13) comprend un dispositif d'évaluation (16), avec lequel on évalue les impulsions contenues dans la tension aux bornes de la résistance de mesure (R_{I}) pour déterminer la vitesse de rotation du moteur électrique (1).

4. Circuit selon la revendication 1, **caractérisé en ce que** la résistance de mesure (R_{I}), le dispositif de mesure et le dispositif d'évaluation (16) font partie du dispositif de commande (13) et sont disposés dans un boîtier de montage commun.

5. Circuit selon l'une quelconque des revendications 1 à 4, **caractérisé en ce qu'**un transistor de commande (T2), qui forme une partie du dispositif de commande (13), est monté entre une première borne de la résistance (R_{I}) et le transistor bipolaire de sortie (T1), et **en ce que** l'autre borne de la résistance de mesure (R_{I}) est raccordée au collecteur du transistor de sortie (T1).

6. Circuit selon la revendication 5, **caractérisé en ce que** le transistor de commande (T2) est un transistor à effet de champ.

7. Circuit selon la revendication 5, **caractérisé en ce qu'**un amplificateur de réglage (15), qui commande le transistor de commande (T2) sur la base de la fréquence des impulsions mesurées, est monté entre la première borne de la résistance de mesure (R_{I}) et une borne de commande du transistor de commande (T2).

8. Procédé pour mesurer la consommation de courant d'une charge commandée par transistor, en particulier d'un moteur électrique, avec un transistor bipolaire de sortie (T1), qui est monté en étage suiveur de tension, dans lequel la détermination de la consommation de courant de la charge (1) est effectuée par la mesure du courant de commande (I_{T2}) du transistor bipolaire de sortie (T1).

9. Procédé selon la revendication 8, **caractérisé en ce que** l'on évalue les impulsions contenues dans le courant de commande (I_{T2}).
